Europäisches Patentamt

European Patent Office

Office européen des brevets

(11) Veröffentlichungsnummer: **0 487 964 A2**

## EUROPÄISCHE PATENTANMELDUNG

(21) Anmeldenummer: **91119167.4**

(22) Anmeldetag: **11.11.91**

(51) Int. Cl.5: **H02H 9/02**

(30) Priorität: **29.11.90 DE 4038086**

(43) Veröffentlichungstag der Anmeldung:
**03.06.92 Patentblatt 92/23**

(84) Benannte Vertragsstaaten:
**DE FR GB IT**

(71) Anmelder: **SIEMENS AKTIENGESELLSCHAFT**
**Wittelsbacherplatz 2**
**W-8000 München 2(DE)**

(72) Erfinder: **Amann, Heinz**
**Pfarrer Steinstrasse 9**
**W-8046 Garching(DE)**

(54) **Schaltungsanordnung zum Schutz eines feldeffektgesteuerten Halbleiterbauelementes gegen Überlast.**

(57) Zum Schutz eines FET oder IGBT (1) gegen Überlast wird dessen Gate-Source-(Emitter)-Spannung überwacht. Bei Anstieg des Laststroms steigt diese an. Wird sie größer als ein Referenzwert, wird ein zwischen Gate und Source (Emitter) liegender Schalter (5) leitend gesteuert, der die Gate-Source-(Emitter)-Spannung absenkt.

FIG 3

Die Erfindung bezieht sich auf eine Schaltungsanordnung zum Schutz eines durch Feldeffekt steuerbaren Halbleiterbauelementes gegen Überlastung.

Solche Schaltungsanordnungen sind z. B. in den veröffentlichten europäischen Patentanmeldungen 0 369 048 und 0 384 937 beschrieben worden. Bei diesen wird die Drain-Sourcespannung am Halbleiterbauelement, einem MOS-Leistungstransistor, ausgewertet. Übersteigt diese Spannung bei Überlast einen bestimmten Wert, so wird die Gate-Sourcespannung verringert, wodurch der Drainstrom ebenfalls kleiner wird.

Schaltungsanordnungen dieser Art sind insbesondere dann nachteilig, wenn am Halbleiterbauelement, z. B. einem Leistungs-MOSFET oder IGBT eine hohe Drain-Sourcespannung bzw. Drain-Emitterspannung anliegt. In diesem Fall muß die Auswerteschaltung ebenfalls für diese hohe Spannung ausgelegt sein.

Ziel der Erfindung ist es, eine Schaltungsanordnung der oben erwähnten Gattung derart weiterzubilden, daß die Auswerteschaltung an einer vergleichsweise niedrigen Spannung liegen kann.

Dieses Ziel wird erreicht durch einen zwischen Gateanschluß und Sourceanschluß (Emitteranschluß) angeschlossenen Sensor, der ein Signal abgibt, wenn die zwischen den genannten Anschlüsse liegende Spannung einen vorgegebenen Wert übersteigt, und durch einen zwischen Gateanschluß und Sourceanschluß (Emitteranschluß) liegenden Schalter, der vom Signal des Sensors leitend gesteuert wird.

Der wesentliche Vorteil der Erfindung besteht darin, daß nur die Gate-Sourcespannung (Gate-Emitterspannung) überwacht werden muß, die in der Größenordnung von 10 bis 20 Volt liegt. Die Erfindung macht sich dabei die Eigenschaften feldeffektgesteuerter Halbleiterbauelemente zunutze, daß der Drainstrom (Emitterstrom) mit der Gate-Sourcespannung über die Übertragungssteilheit $g_{fs}$ verknüpft ist.

Die Erfindung wird anhand einiger Ausführungsbeispiele in Verbindung mit den FIG 1 bis 6 näher erläutert. Es zeigen

FIG 1 bis 4 vier verschiedene Ausführungsbeispiele

FIG 5 den zeitlichen Spannungsverlauf am Gate eines feldeffektgesteuerten Halbleiterbauelements im Normalfall und bei zwei charakteristischen Überlastfallen und

FIG 6 den zeitlichen Verlauf des Kollektorstroms in den genannten Fällen.

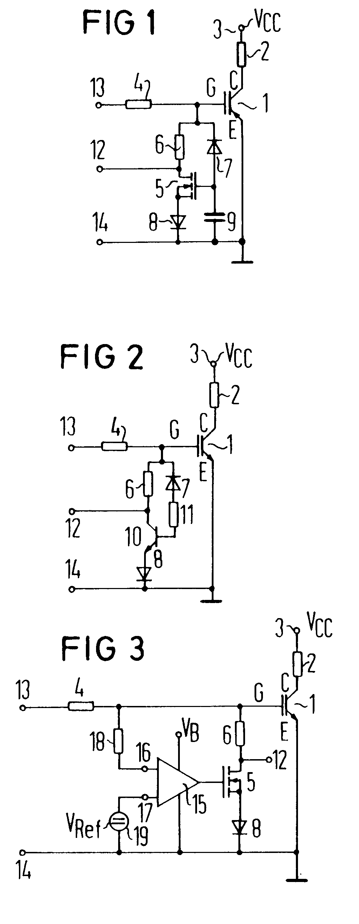

Die Schaltungsanordnung nach FIG 1 enthält einen IGBT 1, dem kollektorseitig eine Last 2 in Reihe geschaltet ist. Die Reihenschaltung liegt über die Klemmen 13, 14 an einer Speisespannung $V_{CC}$. Zwischen Gateanschluß G und Emitteranschluß E des IGBT ist eine Sensorschaltung angeschlossen. Diese enthält eine Zenerdiode 7, der ein Kondensator 9 in Reihe geschaltet ist. Der Reihenschaltung aus Zenerdiode 7 und Kondensator 9 ist die Reihenschaltung eines Widerstandes 6, eines MOSFET 5 und einer Diode 8 parallelgeschaltet. Der Knoten zwischen Zenerdiode 7 und Kondensator 9 ist mit dem Gateanschluß des MOSFET 5 verbunden. Zwischen dem Gateanschluß G und einer Eingangsklemme 13 ist ein Widerstand 4 angeschlossen.

Der IGBT 1 wird durch Anlegen einer positiven Steuerspannung an die Klemmen 13, 14 leitend gesteuert. Dann fließt ein Laststrom durch die Last 2 und den IGBT 1. Im stationären Zustand wird der Laststrom durch die Höhe der Betriebsspannung $V_{CC}$ und die Steuerspannung $u_{GE}$ bestimmt. Erhöht sich nun der Laststrom z. B. durch teilweisen Kurzschluß der Last 2, so wirkt sich dies am Gateanschluß des IGBT in einer Erhöhung der Steuerspannung $u_{GE}$ aus. Wird dabei die Zenerspannung der Zenerdiode 7 überschritten, so wird diese leitend und der Kondensator 9 wird aufgeladen. Bei Überschreiten der Einsatzspannung des MOSFET 5 wird dieser leitend und ein Teil des Gatestroms fließt durch den Widerstand 6, den MOSFET 5 und die Diode 8 zur KLemme 14 bzw. Masse. Damit wird die Steuerspannung $u_{GE}$ etwa auf die Zenerspannung begrenzt. Diese Schaltung hat den Vorteil, daß durch den MOSFET 5, verglichen mit einer Zenerdiode gleicher Chipfläche, wesentlich mehr Strom fließen kann. Die Begrenzung von $u_{GE}$ ist daher wirksamer als bei einer alleinigen Verwendung einer Zenerdiode. Die Diode 8 verhindert einen Stromfluß durch die parasitäre Diode des MOSFET 5, wenn zum Abschalten des IGBT eine negative Steuerspannung angelegt wird.

Beim Einschalten des MOSFET 5 sinkt seine Drainspannung ab. Wird sein Drainanschluß mit einer Klemme 12 verbunden, so kann der Spannungsabfall dort als Überlastsignal detektiert werden.

Die Schaltungsanordnung nach FIG 2 unterscheidet sich von der nach FIG 1 im wesentlichen dadurch, daß der MOSFET 5 durch einen Bipolartransistor 10 ersetzt ist. Der Basisanschluß des Bipolartransistors 10 ist über einen Widerstand 11 mit der Zenerdiode 7 verbunden. Steigt die Steuerspannung $u_{GE}$ am IGBT bedingt durch Überlast an, so wird bei Überschreiten der Zenerspannung die Zenerdiode 7 leitend, wodurch der Biopolartransistor 10 leitend gesteuert wird. Damit wird die Steuerspannung etwa auf einen durch die Zenerdiode 7 vorgegebenen Wert begrenzt und eine wirksame Begrenzung des Stroms durch den IGBT 1 wird erreicht. Ein Überlastsignal kann wieder an der Klemme 12 detektiert werden, die mit dem Kollektor des Bipolartransistors 10 verbunden ist. Die Diode 8 verhindert eine Sperrbelastung des Emitter-Basis-pn-Übergangs des Bipolartransistors, wenn zum Abschalten des IGBT eine negative Steuerspannung angelegt wird.

Die Schaltungsanordnung nach FIG 3 enthält als Sensor einen Komparator 15, dessen erstem Eingang 16 die Steuerspannung $u_{GE}$ über einen Widerstand 18 zugeführt wird. Am zweiten Eingang 17 des Komparators 15 liegt eine Referenzspannung $V_{Ref}$, die aus einer Referenzspannungsquelle 19 gewonnen wird. Der Ausgang des Komparators 15 steuert den MOSFET 5 leitend, dem wie in FIG 1 sourceseitig die Diode 8 und drainseitig der Widerstand 6 in Reihe geschaltet ist.

Übersteigt wegen Überlast die Steuerspannung $u_{GE}$ die Referenzspannung, so erscheint am Ausgang des Komparators 15 ein Signal, das den MOSFET 5 leitend steuert. Damit wird die Steuerspannung am IGBT 1 abgesenkt und der Transistorstrom herabgesetzt. Um welchen Betrag die Steuerspannung gesenkt wird, hängt vom Teilerverhältnis der Widerstände 4, 18 einerseits und 4, 6 andererseits ab. Das Absinken der Drainspannung des MOSFET 5 kann wieder an der Klemme 12 als Überlastsignal detektiert werden.

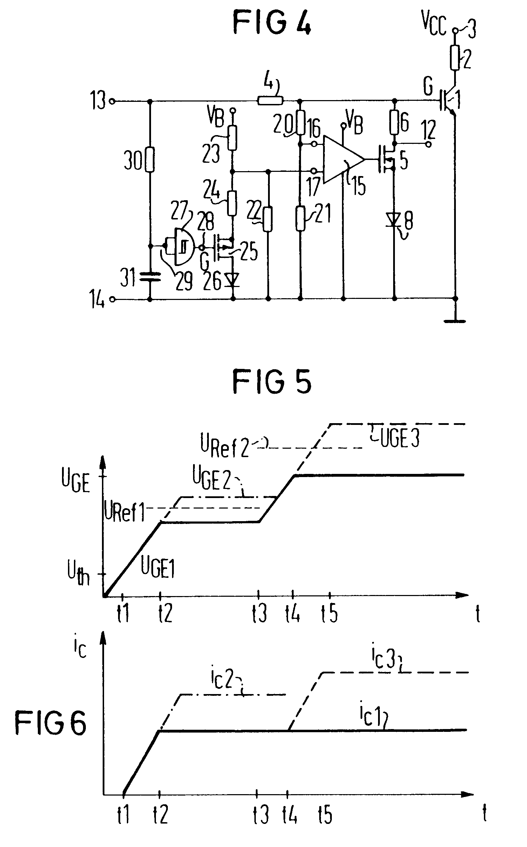

In FIG 4 ist eine Schaltungsanordnung dargestellt, mit der zwei charakteristische Überlastfälle erkannt und bekämpft werden können. Der erste Fall entspricht der zuvor beschriebenen Überlast, während der zweite Fall der Kurzschluß der voll eingeschalteten Last ist. Diese Fälle werden zunächst anhand der FIG 5 und 6 erläutert. Dabei zeigt FIG 5 den charakteristischen Anstieg der Steuerspannung an einem IGBT im Normalfall ($u_{GE1}$), im Überlastfall ($u_{GE2}$) und beim Kurzschluß auf eine eingeschaltete Last ($u_{GE3}$). Wird zum Zeitpunkt $t = 0$ an den IGBT 1 eine Steuerspannung angelegt, so steigt diese zunächst bis zur Einsatzspannung $u_{th}$ an, ohne daß ein Strom fließt (FIG 6). Dann steigt die Spannung $u_{GE1}$ bis zur Zeit t2 weiter an. Zur Zeit t1 beginnt ein Strom zu fließen, der bis zur Zeit t2 ansteigt (FIG 6). Vom Zeitpunkt t2 bleibt die Steuerspannung im wesentlichen bis zum Zeitpunkt t3 konstant, um dann bis zum Zeitpunkt t4 wegen Aufladen der Eingangskapazität $C_{iss}$ weiter anzusteigen. Ab dem Zeitpunkt t4 sind alle Kapazitäten des IGBT aufgeladen und die Steuerspannung steigt im Normalfall nicht weiter an.

Bei Überlast steigt die Steuerspannung jedoch beginnend mit dem Zeitpunkt t2 weiter an und stellt sich dann auf einen durch den Laststrom bestimmten Wert $u_{GE2}$ an. Soll dieser Überlastfall detektiert werden, so muß die Steuerspannung von der Zeit t2 bis zur Zeit t3 mit einer ersten Referenzspannung $U_{Ref1}$ verglichen werden. Wird diese Referenzspannung überschritten, so wird die Steuerspannung wie in Verbindung mit den FIG 1 bis 3 beschrieben abgesenkt und Überlast wird detektiert.

Wird die zum Zeitpunkt t3 voll eingeschaltete Last 2 kurzgeschlossen, so steigt der Strom durch den IGBT erst ab t3 über den Normalwert an. Ebenso steigt die Steuerspannung an, bis der in FIG 5 mit $u_{GE3}$ bezeichnete Wert erreicht ist. Diese Spannung ist größer als eine zweite Referenzspannung $U_{Ref2}$.

In FIG 6 sind die entsprechenden Stromverläufe dargestellt. Dabei zeigt $i_{C1}$ den Strom durch den IGBT 1 im Normalfall, $i_{C2}$ den Überlastfall und $i_{C3}$ den Strom im Kurzschlußfall.

Die Schaltungsanordnung nach FIG 4 unterscheidet sich von der nach FIG 3 hauptsächlich dadurch, daß verschiedene zwei Referenzspannungen eingestellt werden können. Eine der Steuerspannung proportionale Spannung wird dem ersten Eingang 16 des Komparators 15 über einen Spannungsteiler 20, 21 zugeführt, der zwischen dem Gateanschluß des IGBT 1 und der Klemme 14 bzw. Masse liegt. Der zweite Eingang 17 des Komparators 15 ist mit dem Knoten zweier Spannungsteiler verbunden. Der erste Spannungsteiler besteht aus einem Widerstand 23 und einem Widerstand 22. Der zweite Spannungsteiler besteht aus dem Widerstand 23 und einer Reihenschaltung, die ihrerseits aus einem Widerstand 24, einem p-Kanal MOSFET 25 und einer Diode 26 besteht. Beide Spannungsteiler liegen an einer Versorgungsspannung $V_B$. Der Gateanschluß des MOSFET 25 ist mit dem Ausgang 28 einer Verzögerungsschaltung 27 verbunden. Diese hat einen Eingang 29, der mit dem Abgriff eines aus einem Widerstand 30 und eines Kondensators 31 liegenden Spannungsteilers verbunden ist. Der Spannungsteiler liegt zwischen den Klemmen 13 und 14.

Der IGBT wird über eine Spannung an der Klemme 13 eingeschaltet. Das Steuersignal für den IGBT 1 gelangt auch zum Eingang 29 der Verzögerungsschaltung 27. An seinem Ausgang 28 liegt in der Verzögerungszeit noch eine Spannung an, die den MOSFET 25 leitend hält. Damit liegt am zweiten Eingang 17 des Komparators 15 eine Referenzspannung an, die durch das Spannungsteilerverhältnis der Widerstände 23, 24, des MOSFET 25 und der Diode 26 bestimmt ist. Diese Referenzspannung ist in FIG 5 mit $U_{Ref1}$ bezeichnet. Steigt die Steuerspannung bedingt durch Überlast zwischen t2 und t3 an, so wird über den Komparator 15 der MOSFET 5 eingeschaltet und die Steuerspannung wird wie in Verbindung mit FIG 3 beschrieben abgesenkt.

Ist der Strom durch den IGBT während des Einschaltens zunächst normal und tritt zum Zeitpunkt t4 ein Kurzschluß der Last 2 ein, so wird die Steuerspannung größer als die Referenzspannung

$U_{Ref2}$. Diese Referenzspannung wird durch das Spannungsteilerverhältnis der Widerstände 23 und 22 bestimmt. Dieser Spannungsteiler wird dadurch eingeschaltet, daß der MOSFET 25 gesperrt wird. Dies ist bedingt durch die Verzögerungsschaltung 27 zum Zeitpunkt t3 der Fall. Die Verzögerungszeit der Verzögerungsschaltung 27 muß daher mindestens so groß wie t3 und höchstens so groß wie t4 sein.

Die Erfindung wurde anhand eines IGBT beschrieben. Als Leistungs-Halbleiterbauelement kann anstelle des IGBT jedoch auch ein Leistungs-MOSFET verwendet werden. Die Steuerspannung ist dann die zwischen Gate und Source anliegende Spannung $u_{GS}$.

**Patentansprüche**

1. Schaltungsanordnung zum Schutz eines durch Feldeffekt steuerbaren Halbleiterbauelementes gegen Überlastung, **gekennzeichnet durch** einen zwischen Gateanschluß (G) und Sourceanschluß (Emitteranschluß (E)) angeschlossenen Sensor, der ein Signal abgibt, wenn die zwischen den genannten Anschlüssen liegende Spannung einen vorgegebenen Wert übersteigt, und durch einen zwischen Gateanschluß und Sourceanschluß (Emitteranschluß) liegenden Schalter (5, 10), der vom Signal des Sensors leitend gesteuert wird.

2. Schaltungsanordnung nach Anspruch 1, **dadurch gekennzeichnet,** daß der Sensor eine Zenerdiode (7) enthält, deren erster Anschluß mit dem Gateanschluß (G) des Halbleiterbauelementes (1) verbunden ist, daß der Schalter ein Halbleiterschalter (5, 10) mit einem Steuereingang ist und daß der andere Anschluß der Zenerdiode mit dem Steuereingang verbunden ist.

3. Schaltungsanordnung nach Anspruch 1, **dadurch gekennzeichnet,** daß der Sensor einen Komparator (15) enthält, dessen erstem Eingang (16) die zwischen Gateanschluß und Sourceanschluß (Emitteranschluß) liegende Spannung und dessen zweitem Eingang (17) die Referenzspannung ($V_{Ref}$) zugeführt wird, daß der Schalter ein Halbleiterschalter mit einem Steuereingang ist, und daß der Steuereingang mit dem Ausgang des Komparators (15) verbunden ist.

4. Schaltungsanordnung nach Anspruch 3, **dadurch gekennzeichnet,** daß am zweiten Eingang (17) des Komparators (15) eine erste Referenzspannung ($V_{Ref1}$) und nach einer vorgegebenen Zeit eine zweite, größere Referenzspannung ($V_{Ref2}$) angelegt ist.

5. Schaltungsanordnung nach Anspruch 4, **gekennzeichnet durch** die Merkmale:
   a) Es sind zwei voneinander verschiedene, an einer vorgegebenen Spannung (VB) liegende Spannungsteiler (23, 24; 23, 22) vorgesehen,
   b) die Abgriffe der Spannungsteiler sind mit dem zweiten Eingang (17) des Komparators (15) verbunden,
   c) einem der Spannungsteiler ist ein weiterer Halbleiterschalter (25) in Reihe geschaltet,
   d) der Steuereingang des weiteren Halbleiterschalters ist mit dem Ausgang (28) einer Verzögerungsschaltung (27) verbunden,
   e) der Eingang (29) der Verzögerungsschaltung ist mit einer Eingangsklemme (13) verbunden,
   f) die Eingangsklemme ist mit dem Gateanschluß des durch Feldeffekt steuerbaren Halbleiterbauelementes (1) verbunden.

6. Schaltungsanordnung nach Anspruch 5, **dadurch gekennzeichnet,** daß zwischen dem Gateanschluß (G) und der Eingangsklemme (13) ein Widerstand (4) eingeschaltet ist.

FIG 1

FIG 2

FIG 3

5

# FIG 4

# FIG 5

# FIG 6